Europäisches Patentamt

European Patent Office

Office européen des brevets

(11) Veröffentlichungsnummer: **0 214 492 B1**

(12) **EUROPÄISCHE PATENTSCHRIFT**

(45) Veröffentlichungstag der Patentschrift: **27.11.91**

(51) Int. Cl.⁵: **H03H 1/00**

(21) Anmeldenummer: **86111193.8**

(22) Anmeldetag: **13.08.86**

(54) **Hochfrequenz-Durchführungsfilter.**

(30) Priorität: **04.09.85 DE 3531531**

(43) Veröffentlichungstag der Anmeldung:
**18.03.87 Patentblatt 87/12**

(45) Bekanntmachung des Hinweises auf die
Patenterteilung:
**27.11.91 Patentblatt 91/48**

(84) Benannte Vertragsstaaten:
**CH DE FR LI SE**

(56) Entgegenhaltungen:
**EP-A- 0 169 053**
**DE-A- 3 326 629**
**US-A- 4 173 745**

**PATENT ABSTRACTS OF JAPAN, Band 9, Nr.
23 (E-293)[1746], 30. Januar 1985; & JP-A-59
169 216 (NIPPON DENKI K.K.) 25-09-1984**

**JOURNAL OF ELECTRONIC ENGINEERING,
Band 18, Nr. 174, Juni 1981, Seiten 51-69,
Tokyo, JP; "Spread of semiconductorapplied technology raises need for noise
filters"**

**PATENT ABSTRACTS OF JAPAN, Band 9, Nr.
244 (E-346)[1967], 30. September 1985; & JP-**

**A-60 94 515 (NIPPON DENSO K.K.) 27-05-1985**

**PATENT ABSTRACTS OF JAPAN, Band 9, Nr.
248 (E-347)[1971], 4. Oktober 1985; & JP-A-60
96 911 (NIPPON DENSO K.K.) 30-05-1985**

(73) Patentinhaber: **ROBERT BOSCH GMBH**
**Postfach 50**
**W-7000 Stuttgart 1(DE)**

(72) Erfinder: **Franke, Manfred**
**Stubenrauchstrasse 53**
**W-1000 Berlin 41(DE)**
Erfinder: **Böttcher, Ralph**
**Karl-Max-Strasse 245**
**W-1000 Berlin 44(DE)**
Erfinder: **Waizenegger, Dieter**
**Gerdsmeyerweg 8**
**W-1000 Berlin 42(DE)**

(74) Vertreter: **Schmidt, Hans-Ekhardt**
**Robert Bosch GmbH Geschäftsbereich Elektronik Patent- und Lizenzabteilung Forckenbeckstrasse 9-13**
**W-1000 Berlin 33(DE)**

## Beschreibung

### Stand der Technik

Die Erfindung geht von einem Hochfrequenz-Durchführungsfilter nach der Gattung des Anspruchs 1 aus.

Es sind schon Hochfrequenz-Durchführungsfilter bekannt, die nach Art eines rohrförmigen Durchführungskondensators ausgebildet sind. Derartige Durchführungsfilter können nicht angewendet werden, wenn der dafür erforderliche Platz, wie zum Beispiel bei in der Hand zu haltenden Funkgeräten, nicht vorhanden ist. Besonders schwierig gestaltet sich die Unterbringung der bekannten Durchführungskondensatoren, wenn mehrere Leitungsdurchführungen dicht nebeneinander, zum Beispiel in Form einer Steck- oder Lötleiste mit verhältnismäßig geringem Rastermaß, vorgesehen sind. Weiterhin sind nicht als Durchführungsfilter konzipierte Hochfrequenz-Filter in Streifenleitertechnik bekannt (Neues von Rhode & Schwarz, Heft 93, Frühjahr 1981, Seite 34).

### Vorteile der Erfindung

Das erfindungsgemäße Hochfrequenz-Durchführungsfilter mit den kennzeichnenden Merkmalen des Anspruchs 1 hat den Vorteil, daß ein besonders raumsparender Aufbau möglich ist. Als weiterer Vorteil ist anzusehen, daß für das erfindungsgemäße Hochfrequenz-Durchführungsfilter keine zusätzlichen Bauelemente benötigt werden.

Durch die in den Unteransprüchen aufgeführten Maßnahmen sind vorteilhafte Weiterbildungen und Verbesserungen des im Anspruch 1 angegebenen Hochfrequenz-Durchführungfilters möglich. Besonders vorteilhaft ist ein erfindungsgemäßes Hochfrequenz-Durchführungsfilter, bei dem die Bereiche der Metallkaschierung derart keilförmig ausgebildet und derart auf einer Isolierstoffplatte angeordnet sind, daß sie in einem Randbereich der Platte schmale Vorsprünge bilden, die von den Kontaktstiften durchsetzt sind. Ein derartiges Mehrfach-Durchführungsfilter läßt sich besonders bei eng beieinanderliegenden Durchführungsleitern einsetzen. Die keilförmigen Bereiche der Metallkaschierung ergeben in der Nähe der Durchführungsleiter kleine Kapazitatswerte für hohe Frequenzen, während sich in weiterer Entfernung von den Durchführungsleitern eine größere Kapazität für niedrigere Frequenzen ergibt.

### Zeichnung

Ausführungsbeispiele der Erfindung sind in der Zeichnung an Hand mehrerer Figuren dargestellt und in der nachfolgenden Beschreibung näher erläutert. Die Zeichnung zeigt in

Fig. 1    eine Schnittansicht eines hochfrequenzdichten Gehäuses mit einem erfindungsgemäßen Mehrfach-Hochfrequenz-Durchführungsfilter,

Fig. 2    eine Schnittansicht des Gehäuses nach Fig. 1 gemäß dem Schnittverlauf II - II,

Fig. 3    einen Ausschnitt aus dem Gehäuseunterteil mit einem Durchführungsfilter in einer ersten Ausführungsform,

Fig. 4    einen Ausschnitt aus dem Gehäuseunterteil mit einem Durchführungsfilter in einer zweiten Ausführungsform und

Fig. 5    einen Ausschnitt aus dem Gehäuseunterteil mit einem Durchführungsfilter in einer dritten Ausführungsform.

### Beschreibung der Erfindung

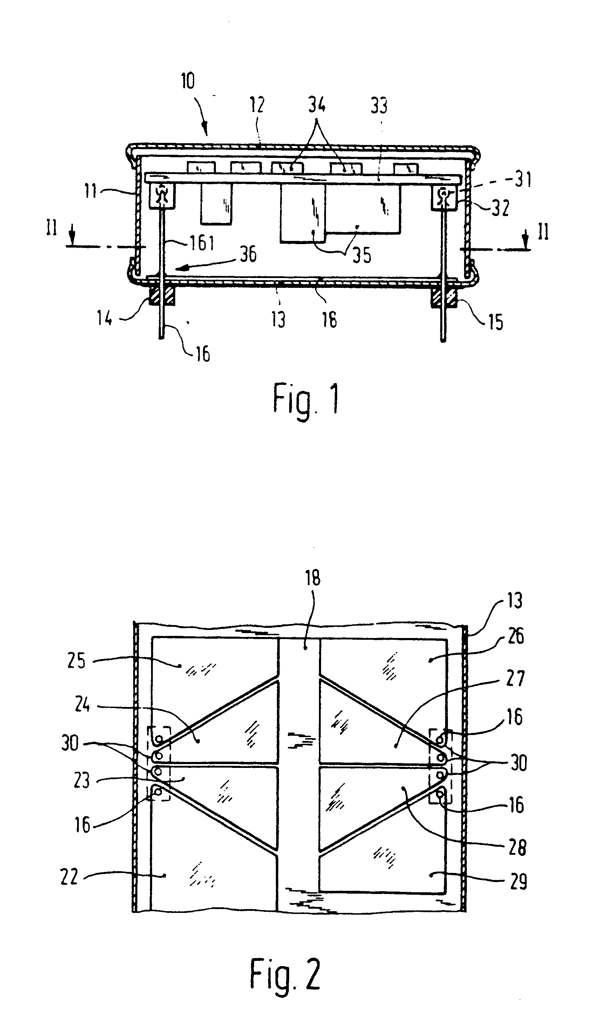

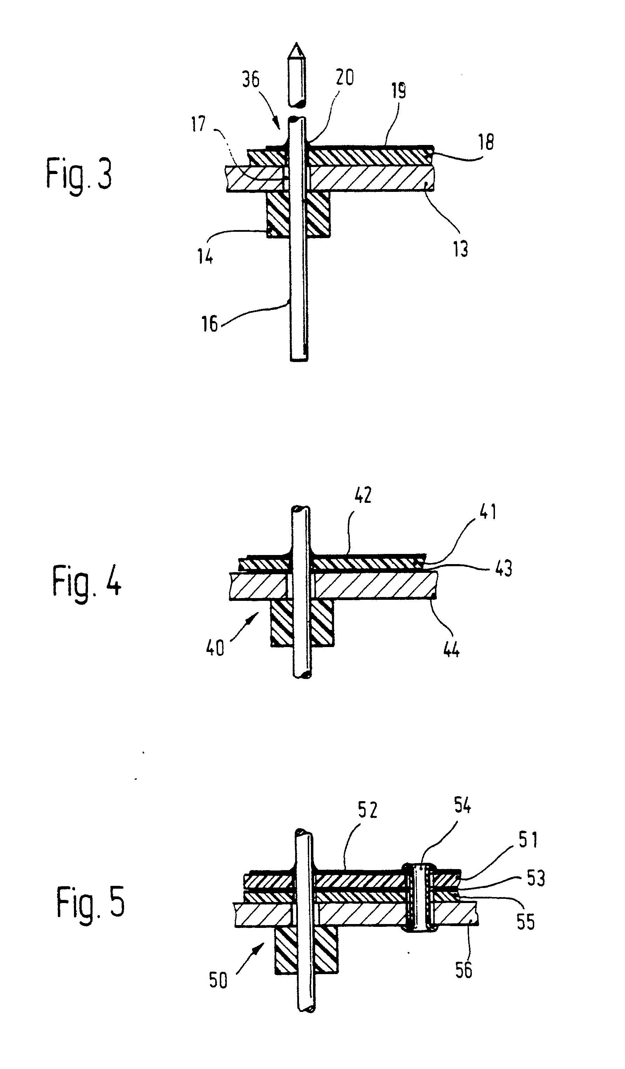

In Fig. 1 bezeichnet 10 ein hochfrequenzdichtes Gehäuse aus Blech oder metallkaschiertem Kunststoff, das aus einem rechteckigen Rahmen 11, einem deckelförmigen Gehäuseoberteil 12 und einem vorzugsweise ebenfalls deckelförmigen Gehäuseunterteil 13 besteht. An dem Gehäuseunterteil 13 sind zwei Steckverbinder 14, 15 mit Kontaktstiften 16 vorgesehen, die durch Öffnungen 17 (vgl. Fig. 3) des Gehäuseunterteils 13 frei hindurchgeführt sind. Auf dem Innenseite des Gehäuseunterteils ist eine Isolierstoffplatte oder -folie 18 angeordnet, die auf ihrer Oberseite eine Metallkaschierung 19 trägt. Die Kontaktstifte 16 durchsetzen die Isolierstoffplatte 18 und die Metallkaschierung 19 und sind mit der Oberfläche der Metallkaschierung zum Beispiel durch Löten leitend verbunden; vgl. Lötstelle 20 in Fig. 3.

Die Metallkaschierung 19 ist entsprechend Fig. 2 in mehrere gegeneinander isolierte Bereiche 22 ... 25 und 26 ... 29 aufgeteilt, wobei jedem Kontaktstift 16 ein Bereich zugeordnet ist. Die Bereiche sind derart keilförmig geformt und auf der Isolierstoffplatte 18 derart angeordnet, daß jeder Bereich einen schmalen Vorsprung 30 aufweist. Die Vorsprünge sind in einem Randbereich der Isolierstoffplatte 18 eng nebeneinander angeordnet, so daß sie von den Kontaktstiften 16 der Kontaktleisten 14, 15 durchsetzt werden können. Die Länge des in das Gehäuse 10 hineinragenden Teils 161 der Kontaktstifte 16 ist derart bemessen, daß die Kontaktstifte mit ihren freien Enden in Buchsen 31 von Buchsenleisten 32 passen, die auf Randbereichen einer Leiterplatte 33 angeordnet sind, welche vorzugsweise oberhalb und unterhalb elektrische Bauelemente 34 und Baustufen 35 trägt.

Die Wirkungsweise der vorstehend beschriebenen Vorrichtung ist folgende. Jeder metallische Bereich, zum Beispiel 22 in Fig. 2, der Isolierstoffplatte 18 bildet in Verbindung mit dem metallischen Gehäuseunterteil 13 einen planaren Kondensator und der zugehörige Kontaktstift 16 eine Induktivität. Kondensator und Induktivität ergeben zusammen ein erfindungsgemäßes Hochfrequenz-Durchführungsfilter 40 (vgl. Fig. 1 und 3).

Nach einer in Fig. 4 gezeigten Variante eines Durchführungsfilters 40 trägt eine Isolierstoffplatte 41, die der Isolierstoffplatte 18 in Fig. 2 entspricht, auf ihrer Oberseite eine Metallkaschierung 42 entsprechend der in Bereiche 22 ... 29 aufgeteilten Metallkaschierung 19 in Fig. 3. Auf der Unterseite trägt die Isolierstoffplatte 41 eine vollständige Metallkaschierung 43, die mit dem Gehäuseunterteil 44 zumindest punktweise verbunden ist. Dadurch wird eine größere Kapazität für den Kondensator des Hochfrequenz-Durchführungsfilters erzielt.

Ein anderes Hochfrequenz-Durchführungsfilter 50 nach Fig. 5 weist eine Isolierstoffplatte 51 mit beidseitigen Metallkaschierungen 52, 53 wie in Fig. 4 auf. Die obere, in Bereiche aufgeteilte Metallkaschierung 52 ist jedoch, zum Beispiel mittels Hohlniete 54, die durch Offnungen in den kaschierungen 52 und 53, der Isolierstoffplatte 51, einer Isolierstoff-Zwischenlage 55 und einem Gehäuseunterteil 56 geführt sind, mit dem Gehauseunterteil leitend verbunden. Dadurch entstehen zwei parallelgeschaltete Kondensatoren, die zu einer Verdopplung des Kapazitätswertes führen. Außerdem ergibt sich bei der Ausführung nach Fig. 5 eine höhere Hochfrequenz-Abschirmwirkung.

## Patentansprüche

1. Hochfrequenz-Durchführungsfilter für durch eine leitende Gehäusewand geführte Leitungen, dadurch gekennzeichnet, daß das Durchführungsfilter (36) durch einen Kondensator in Streifenleitungstechnik und die Induktivität durch eine durch die Gehäusewand (13) isoliert geführte und den Kondensator durchsetzende Durchführungsleitung (16) gebildet ist.

2. Hochfrequenz-Durchführungsfilter nach Anspruch 1, dadurch gekennzeichnet, daß der Kondensator durch einen Bereich (22) einer Metallkaschierung (19) einer Isolierstoffplatte (18) in Verbindung mit der unterhalb der Isolierstoffplatte angeordneten Gehäusewand (13) gebildet ist.

3. Hochfrequenz-Mehrfach-Durchführungsfilter umfassend mehrere Hochfrequenz-Durchführungsfilter nach Anspruch 2, dadurch gekennzeichnet, daß die Bereiche (22) der Metallkaschierung (19) derart keilförmig ausgebildet und derart auf einer Isolierstoffplatte (18) angeordnet sind, daß sie in einem Randbereich der Platte schmale Vorsprünge (30) bilden, die von Kontaktstiften (16) durchsetzt sind, die die Durchführungsleitungen bilden.

4. Hochfrequenz-Mehrfach-Durchführungsfilter nach Anspruch 3, dadurch gekennzeichnet, daß mehrere Kontaktstifte (16) zu einer Steckerleiste (14) zusammengefaßt sind.

5. Hochfrequenz-Mehrfach-Durchführungsfilter nach Anspruch 3, dadurch gekennzeichnet, daß die Isolierstoffplatte (41) auf ihrer der Gehäusewand (13) abgewandten Seite eine in Bereiche (22) aufgeteilte Metallkaschierung (42) und auf der gegenüberliegenden Seite eine vollständige Metallkaschierung (43) trägt, die zumindest teilweise mit der Gehäusewand (44) leitend verbunden ist.

6. Hochfrequenz-Mehrfach-Durchführungsfilter nach Anspruch 3, dadurch gekennzeichnet, daß die Isolierstoffplatte (51) auf der der Gehäusewand (56) zugewandten Seite die in Bereiche aufgeteilte Metallkaschierung (53) trägt, daß die in Bereiche (22) aufgeteilte Metallkaschierung (53) durch eine isolierende Zwischenlage (55) gegenüber der Gehäusewand (56) isoliert ist, daß die Isolierstoffplatte (51) auf ihrer Außenseite eine vollständige Metallkaschierung (52) trägt und daß Gehäusewand, isolierende Zwischenlage und die Isolierstoffplatte mit den Metallkaschierungen Öffnungen für mindestens ein Hohlniet (54) aufweisen, das die äußere Metallkaschierung (52) und die Gehäusewand (56) leitend miteinander verbindet.

## Claims

1. High-frequency lead-through filter for lines which are lead through a conductive housing wall, characterised in that the lead-through filter (36) is formed by a capacitor in strip conductor technology and the inductor is formed by a lead-through line (16) which is lead in an insulated manner through the housing wall (13) and penetrates through the capacitor.

2. High-frequency lead-through filter according to claim 1, characterised in that the capacitor is formed by a region (22) of a metal cladding (19) of an insulating material plate (18) in conjunction with the housing wall (13), which is disposed underneath the insulating material plate.

3. High-frequency multiple lead-through filter comprising a plurality of high-frequency lead-through filters according to claim 2, characterised in that the regions (22) of the metal cladding (19) are wedge-shaped and disposed on the insulating material plate (18) in such a way that, in an edge region of the plate, they form narrow projections (30), through which contact pins (16), which form the lead-through lines, penetrate.

4. High-frequency multiple lead-through filter according to claim 3, characterised in that a plurality of contact pins (16) are combined to form a multipoint connector (14).

5. High-frequency multiple lead-through filter according to claim 3, characterised in that, on its side remote from the housing wall (13), the insulating material plate (41) carries a metal cladding (42), which is divided into regions (22), and, on the opposite side, it carries a complete metal cladding (43), which is conductively connected at least in part to the housing wall (44).

6. High-frequency multiple lead-through filter according to claim 3, characterised in that, on its side facing the housing wall (56), the insulating material plate (51) carries the metal cladding (53), which is divided into regions, the metal cladding (53), which is divided into regions (22), is insulated from the housing wall (56) by an insulating intermediate layer (55), the insulating material plate (51) has a complete metal cladding (52) on its outside, and housing wall, insulating intermediate layer and the insulating material plate with the metal claddings have openings for at least one hollow rivet (54), which conductively connects the outer metal cladding (52) to the housing wall (56).

## Revendications

1. Filtre de passage à haute fréquence pour des conducteurs traversant une paroi de boîtier conductrice, caractérisé en ce que le filtre de passage (36) est formé par un condensateur en technique à chemin conducteur et l'inductance est constituée par un conducteur de passage (16) qui traverse la paroi de boîtier (13) de manière isolée et le condensateur.

2. Filtre de passage à haute fréquence selon la revendication 1, caractérisé en ce que le condensateur est formé par une zone (22), d'un revêtement métallique (19), d'une plaque isolante (18) en liaison avec la paroi de boîtier (13) prévue sous la plaque isolante.

3. Filtre de passages multiples, à haute fréquence, comprenant plusieurs filtres de passages à haute fréquence comprenant plusieurs filtres de passage à haute fréquence selon la revendication 2, caractérisé en ce que les zones (22) des revêtements métalliques (19) sont en forme de coins et sont réalisées d'une manière telle sur une plaque isolante (18) pour former de faibles parties en saillie (30) dans la zone marginale traversée par les fiches de contact (16) qui forment les lignes de passage.

4. Filtre de passages mutiples à haute fréquence selon la revendication 3, caractérisé en ce que plusieurs fiches de contact (16) sont réunies en un longeron de connecteur (14).

5. Filtre de passages multiples à haute fréquence selon la revendication 3, caractérisé en ce que la plaque isolante (41) porte sur sa face opposée à la paroi de boîtier (13), un revêtement métallique (42) subdivisé en zones (22) et sur la face opposée il comporte un revêtement métallique (43) continu qui est relié de manière conductrice, au moins partiellement, à la paroi de boîtier (44).

6. Filtre de passages multiples à haute fréquence selon la revendication 3, caractérisé en ce que la plaque en matériau isolant (51) porte sur la face opposée à la paroi de boîtier (56) un revêtement métallique (53) subdivisé en zones et ce revêtement (53) subdivisé en zones (22) est isolé par rapport à la paroi de boîtier (56) par une couche intermédiaire isolante (55), la plaque en matériau isolant (51) portant un revêtement métallique (52) continu sur sa face extérieure et la paroi de boîtier présente une couche intermédiaire isolante et la plaque de matière isolante avec les orifices dans le revêtement métallique comporte au moins un rivet creux (54) qui relie électriquement le revêtement métallique extérieur (52) et la paroi de boîtier (56).

Fig. 1

Fig. 2

Fig. 3

Fig. 4

Fig. 5

6